(19) **Europäisches Patentamt European Patent Office Office européen des brevets**

(11) **EP 4 119 799 B1**

(12) **EUROPEAN PATENT SPECIFICATION**

| | |
|---|---|
| (45) Date of publication and mention of the grant of the patent: **02.04.2025 Bulletin 2025/14** | (51) International Patent Classification (IPC): **F04D 25/06** (2006.01) **F04D 29/60** (2006.01) **F04D 29/66** (2006.01) **F04D 29/70** (2006.01) |
| (21) Application number: **22184629.8** | (52) Cooperative Patent Classification (CPC): **F04D 29/668; F04D 25/0613; F04D 29/601; F04D 29/703;** Y02B 30/70 |
| (22) Date of filing: **13.07.2022** | |

(54) **FAN ASSEMBLY AND INVERTER**

LÜFTERANORDNUNG UND WECHSELRICHTER

ENSEMBLE VENTILATEUR ET ONDULEUR

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: **13.07.2021 CN 202110790364**

(43) Date of publication of application:
**18.01.2023 Bulletin 2023/03**

(73) Proprietor: **Sungrow Power Supply Co., Ltd.**
**Hefei, Anhui 230088 (CN)**

(72) Inventors:
• **YANG, Xin**
Hefei (CN)
• **ZHOU, Jie**
Hefei (CN)
• **YAO, Qi**
Hefei (CN)

(74) Representative: **Zacco Norway AS**
**P.O. Box 488 Skøyen**
**0213 Oslo (NO)**

(56) References cited:
DE-A1- 19 740 799     US-A- 4 805 868
US-A1- 2008 259 562    US-A1- 2012 195 738
US-A1- 2013 045 108    US-A1- 2015 295 472
US-B1- 6 692 226

## Description

### FIELD

The present application relates to the technical field of heat dissipation for inverters, and in particular to a fan assembly and an inverter.

### BACKGROUND

Since the power of inverters is required to be greater and greater while the volume is required to be smaller and smaller, the heat dissipation of the inverter worsens. Therefore, the performance of the fan assembly is required to be continuously improved, and the air volume of the fan assembly needs to be increased, hence the rotation speed of the fan assembly is higher and higher. However, the increase of the wind speed may increase the fundamental frequency vibration of the fan assembly, resulting in deterioration of the noise and reduction of the sound quality.

Currently, the conventional method for mounting the fan assembly is generally to directly fix a fan body onto a to-be-mounted component through a screw, and mount a fan guard on the fan body. The disadvantage of this method is that the vibration of this structure may be intensified after the rotation speed of the fan body increases, which is very easy to excite the natural frequency of the member in contact with the structure, thus the resonance is formed and the vibration generated by the rotation of the fan assembly is increased. In addition, since the fan body and the fan guard are mounted close to each other, when the fan body rotates at a high speed, the air flows through the fan guard and forms a high-order vortex, which increases the aerodynamic noise and the noise generated by the rotation of the fan assembly.

US6692226 B1 discloses a fan assembly, comprising:a fan body and a noise reduction mounting member; wherein the fan body is arranged to directly face an air inlet, and the air inlet is covered by a fan guard; and the noise reduction mounting member is arranged at the fan body, to provide a preset distance between the fan body and the fan guard, and the noise reduction mounting member is configured to mount the fan body and the fan guard at a fan bracket in a buffered manner, wherein the air inlet is provided on the fan bracket, wherein the noise reduction mounting member comprises: a vibration damper arranged between the fan guard and the fan body, and a fastener configured to connect the fan guard, the vibration damper and the fan body with each other.

### SUMMARY

Some embodiments of the disclosed technology are summarily set out below, however, the invention is defined by the accompanying claims.

An object according to the present application is to provide a fan assembly, which can not only prevent the resonance from being formed between a fan body and a to-be-mounted component (e.g., a fan bracket), but also reduce aerodynamic noises and improve sound quality.

Another object according to the present application is to provide an inverter using the fan assembly, which can not only prevent the resonance from being formed between the fan body and the to-be-mounted component, but also reduce the aerodynamic noise and improve the sound quality under the condition of ensuring efficient heat dissipation of the inverter.

In order to achieve the above objects, the following technical solutions are provided according to the present application.

A fan assembly includes a fan body and a noise reduction mounting member, the fan body is arranged to directly face an air inlet, and the air inlet is covered by a fan guard; the noise reduction mounting member is arranged at the fan body, to provide a preset distance between the fan body and the fan guard, and the noise reduction mounting member is configured to mount the fan body and the fan guard at a fan bracket in a buffered manner. The air inlet is provided on the fan bracket, the noise reduction mounting member includes a vibration damper arranged between the fan guard and the fan body, and the vibration damper is fixed on the fan bracket; and a fastener configured to connect the fan guard, the vibration damper and the fan body with each other, the vibration damper includes: a vibration damping pad fixed on the fan bracket, a through hole is provided in the vibration damping pad; a bushing arranged in the through hole of the vibration damping pad; and a gasket arranged on the bushing, the fastener passes through the fan guard, the gasket, the bushing and the fan body successively to connect the fan guard, the gasket, the bushing and the fan body with each other, a clamping groove is circumferentially provided on an outer periphery of the vibration damping pad, and the fan bracket is clamped and fixed in the clamping groove.

In an embodiment, the vibration damping pad is a rubber pad or a spring.

In an embodiment, a height of the vibration damper is greater than or equal to 10 mm.

In an embodiment, the noise reduction mounting member further includes a nut screwed on the fastener and abutting against the fan body.

In an embodiment, the fan body is integrally formed with the noise reduction mounting member.

In an embodiment, multiple noise reduction mounting members are provided, and the multiple noise reduction mounting members are arranged spaced apart along a circumferential direction of the fan body.

In an embodiment, multiple fan bodies are provided, and the multiple fan bodies are arranged spaced apart on the fan bracket.

An inverter includes the fan assembly according to the above solutions.

In an embodiment, the inverter further includes a box and heat dissipation fins arranged on the box, where the fan assembly is arranged to directly face the heat dissipation fins, and the fan assembly is configured to dissipate heat for the heat dissipation fins.

The beneficial effects according to the present application are as follows.

The fan assembly is provided according to the present application, which includes the fan guard, the fan body and the noise reduction mounting member. The fan body is arranged to directly face the air inlet, the fan guard covers the air inlet, so as to ensure air circulation. The noise reduction mounting member is arranged at the fan body, to provide the preset distance between the fan body and the fan guard, so as to prevent the fan body and the fan guard from being mounted close to each other, the distance between the fan body and the fan guard is increased, which avoids the formation of high-order vortex when the air flows through the fan guard, thereby reducing the aerodynamic noise and improving the sound quality. In addition, the noise reduction mounting member can mount the fan body on the to-be-mounted component in a buffered manner, so that the noise reduction mounting member plays a vibration isolation function between the fan body and the to-be-mounted component, the energy generated by the vibration of the fan body is dissipated by the noise reduction mounting member, thus the excitation of the fan body on the to-be-mounted component becomes small, which increases the loss in transmission of the vibration of the fan body, thereby reducing the noise caused by the vibration of the fan body and improving the sound quality.

The inverter employing the fan assembly is provided according to the present application, which can not only avoid the formation of resonance between the fan body and the to-be-mounted component, but also reduce the aerodynamic noise and improve the sound quality under condition of ensuring efficient heat dissipation of the inverter.

## BRIEF DESCRIPTION OF THE DRAWINGS

FIG. 1 is a schematic view showing the structure of an inverter according to a first embodiment of the present application;

FIG. 2 is a schematic view showing the structure of a fan assembly according to the first embodiment of the present application;

FIG. 3 is a cross-sectional view of part of the fan assembly according to the first embodiment of the present application;

FIG. 4 is an exploded view of the fan assembly provided according to the first embodiment of the present application;

FIG. 5 is a partially enlarged view of portion A in FIG. 3;

FIG. 6 is a schematic view showing the structure of a vibration damping pad according to the first embodiment of the present application; and

FIG. 7 is a schematic view of a fan body and a vibration damping pad according to a second embodiment of the present application.

Reference numerals:

| 100 | fan assembly; | 200 | box; |
|---|---|---|---|
| 300 | heat dissipation fin; | 1 | fan bracket; |
| 11 | air inlet; | 12 | third mounting hole; |
| 2 | fan guard; | 21 | first mounting hole; |
| 3 | fan body; | 31 | second mounting hole; |
| 4 | noise reduction mounting member; | 41 | vibration damper; |

(continued)

| 411 | vibration damping pad; | 4111 | through hole; |
|---|---|---|---|
| 4112 | clamping groove; | 412 | bushing; |
| 413 | gasket; | 42 | fastener; |
| 43 | nut. | | |

## DETAILED DESCRIPTION OF THE EMBODIMENTS

In order to make the technical problems solved by the present application, the technical solutions adopted and the technical effects achieved more clear, the technical solutions of the present application will be further explained below in conjunction with the drawings and embodiments.

### First embodiment

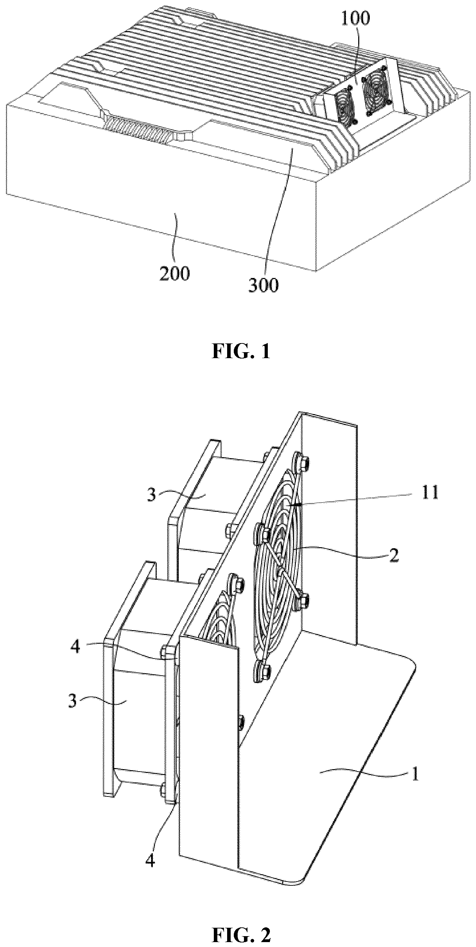

As shown in FIG. 1, a fan assembly 100 is provided according to this embodiment, the fan assembly 100 is generally used to dissipate heat for an inverter, but is not limited to this, and it may also be used to dissipate heat for other devices.

Specifically, as shown in FIG. 2, the fan assembly 100 according to this embodiment includes a fan bracket 1, a fan guard 2 and a fan body 3. An air inlet 11 is provided in the fan bracket 1, the fan guard 2 is configured to cover the air inlet 11, the fan body 3 is mounted on the fan bracket 1 and is arranged to directly face the air inlet 11, the fan guard 2 can ensure the circulation of air at the air inlet 11 and can also protect the fan body 3, to prevent foreign matters from entering the fan body 3 and causing danger, and avoid accidental touch of the fan body 3, thereby ensuring personal safety. The fan body 3 rotates so that the air passes through the fan guard 2 from the air inlet 11 to realize air circulation and realize ventilation and heat dissipation.

However, the conventional method for mounting the fan assembly 100 is generally to directly fix the fan body 3 on the fan bracket 1 through a screw. The disadvantage of this method is that the vibration of this structure may be intensified after the rotation speed of the fan body 3 increases, which is very easy to excite the natural frequency of the member in contact with the structure, thus the resonance is formed and the vibration generated by the rotation of the fan assembly 100 is increased. In addition, since the fan body 3 and the fan guard 2 on the fan bracket 1 are mounted close to each other, when the fan body 3 rotates at a high speed, the air flows through the fan guard 2 and forms a high-order vortex, which increases the aerodynamic noise and the noise generated by the rotation of the fan assembly 100.

In order to solve the above problems, as shown in FIG. 2, the fan assembly 100 according to the present application includes a noise reduction mounting member 4, the noise reduction mounting member 4 is arranged at the fan body 3, to provide a preset distance between the fan body 3 and the fan guard 2, so as to prevent the fan body 3 and the fan guard 2 from being mounted close to each other, the distance between the fan body 3 and the fan guard 2 is increased, which avoids the formation of high-order vortex when the air flows through the fan guard 2, thereby reducing the aerodynamic noise and improving the sound quality.

In addition, the noise reduction mounting member 4 can mount the fan body 3 on the fan bracket 1 in a buffered manner, so that the noise reduction mounting member 4 plays a vibration isolation function between the fan body 3 and the fan bracket 1, the energy generated by the vibration of the fan body 3 is dissipated by the noise reduction mounting member 4, the excitation of the fan body 3 on the fan bracket 1 becomes small, which increases the loss in transmission of the vibration of the fan body 3, thereby reducing the noise caused by the vibration of the fan body 3 and improving the sound quality.

Preferably, as shown in FIG. 2, multiple noise reduction mounting members 4 are provided, and the multiple noise reduction mounting members 4 are arranged spaced apart along a circumferential direction of the fan body 3, which can not only ensure the stable mounting between the fan body 3 and the fan bracket 1, but also further increase the consumption of energy generated by the vibration of the fan body 3, and thereby improving the sound quality.

An inverter employing the fan assembly 100 is provided according to the present application, which can not only avoid the formation of the resonance between the fan body 3 and the fan bracket 1, but also reduce the aerodynamic noise and improve the sound quality under condition of ensuring efficient heat dissipation of the inverter.

In this embodiment, as shown in FIG. 1, the inverter further includes a box 200 and heat dissipation fins 300. The heat dissipation fins 300 are arranged on the box 200, which can dissipate heat for elements inside the box 200, to ensure the normal operation of the inverter. The fan assembly 100 is arranged to directly face the heat dissipation fins 300, and the fan assembly 100 is used to dissipate heat for the heat dissipation fins 300, so as to further improve the heat dissipation effect of the heat dissipation fins 300 for the elements inside the inverter. Specifically, the fan assembly 100 is arranged to directly face to air ducts on the heat dissipation fins 300, which can accelerate the air circulation on the heat dissipation fins 300, and thereby improving the heat dissipation effect of the fan assembly 100 on the heat dissipation fins 300.

Specifically, as shown in FIG. 1 and FIG. 2, the fan bracket 1 is L-shaped, one side wall of the fan bracket 1 is fixed to the box 200, another sidewall of the fan bracket 1 is configured to mount the fan body 3 and the fan guard 2, so that the fan body 3 is arranged to directly face the air ducts on the heat dissipation fins 300. The fan bracket 1 is designed to be L-shaped, which not only increases a mounting area between the fan bracket 1 and the box 200 to ensure that the fixing between the fan assembly 100 and the box 200 is more stable, but also is beneficial to ensuring that the fan body 3 and the air ducts on the heat dissipation fins 300 are arranged to directly face each other, to ensure the heat dissipation effect.

Preferably, as shown in FIG. 1 and FIG. 2, multiple fan bodies 3 are provided, the multiple fan bodies 3 are arranged spaced apart on the fan bracket 1, and the multiple fan bodies 3 are arranged spaced apart along a distribution direction of the heat dissipation fins 300, so as to further improve the heat dissipation effect of the fan assembly 100 on the heat dissipation fins 300, and ensure the normal operation of the inverter.

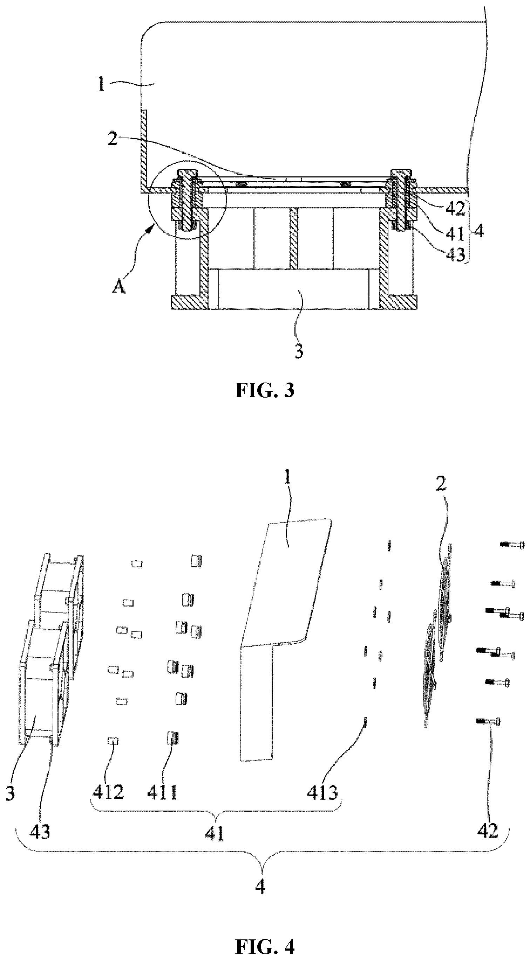

The specific structure of the noise reduction mounting member 4 is illustrated in conjunction with FIG. 3 and FIG. 4. As shown in FIG. 3 and FIG. 4, the noise reduction mounting member 4 includes a vibration damper 41 and a fastener 42, the vibration damper 41 is arranged between the fan guard 2 and the fan body 3, the vibration damper 41 is fixed on the fan bracket 1, and the fastener 42 is configured to connect the fan guard 2, the vibration damper 41 and the fan body 3 with each other. This arrangement can ensure the buffered mounting between the fan bracket 1 and the fan body 3, so that the energy generated by the vibration of the fan body 3 is dissipated by the vibration damper 41. The fastener 42 can pass through the fan guard 2, the vibration damper 41 and the fan body 3 successively to connect the fan guard 2, the vibration damper 41 and the fan body 3 with each other, which can avoid the problem of resonance of the fastener 42 to a certain extent. Specifically, the fastener 42 may be a bolt, which can realize the detachable mounting between the fan guard 2, the vibration damper 411 and the fan body 3. The bolt also has the advantages of high reliability and low cost.

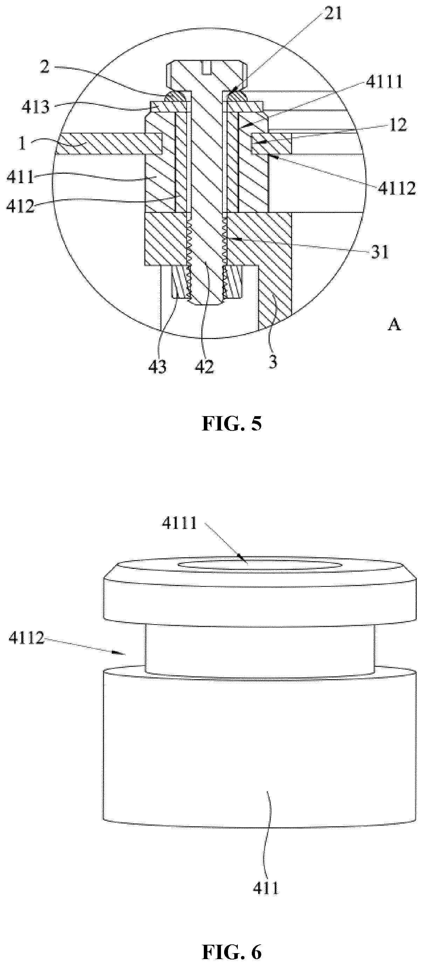

As shown in FIG. 4 and FIG. 5, the vibration damper 41 includes a vibration damping pad 411, a bushing 412 and a gasket 413. The vibration damper 41 is fixed on the fan bracket 1, a through hole 4111 is provided inside the vibration damping pad 411, the bushing 412 is arranged in the through hole 4111 of the vibration damping pad 411, the gasket 413 is arranged on the bushing 412, and the fastener 42 passes through the fan guard 2, the gasket 413, the bushing 412 and the fan body 3 successively to connect the fan guard 2, the gasket 413, the bushing 412 and the fan body 3 with each other. The bushing 412 and the gasket 413 are provided, which can not only ensure the stable connection of the fastener 42 with the fan guard 2 and the fan body 3, to ensure the tightness of the assembly, but also further improve the vibration damping effect of the vibration damper 41, to realize consumption of the vibration of the fan body 3 through multi-layer buffering.

Furthermore, as shown in FIG. 5 and FIG. 6, a clamping groove 4112 is circumferentially provided on an outer periphery of the vibration damping pad 4111, and the fan bracket 1 is clamped and fixed in the clamping groove 4112, which can not only ensure that the vibration damping pad 411 be more firmly clamped on the fan bracket 1, but also increase a contact area between the vibration damping pad 411 and the fan bracket 1, and further increase the anti-vibration and vibration-absorbing effect of the vibration damping pad 411.

Specifically, as shown in FIG. 5, a first mounting hole 21 is provided in the fan guard 2, a second mounting hole 31 is provided in the fan body 3, and the fastener 42 passes through the first mounting hole 21, the gasket 413, the bushing 412 and the second mounting hole 31 successively to connect the fan guard 2 with the fan body 3. The above connection mode has the advantages of compact structure, ingenious design and easy mounting. It should be noted that in this embodiment, a third mounting hole 12 is provided in the fan bracket 1, and the vibration damping pad 411 passes through the third mounting hole 12 and is clamped and fixed in the third mounting hole 12 through the clamping groove 4112.

Preferably, the vibration damping pad 411 is a rubber pad, which has certain elasticity, good vibration damping effect and vibration-absorbing effect, in addition, the rubber pad has a stable structure, is not easy to damage and has low cost. It should be noted that in other embodiments, the vibration damping pad 411 may be a spring, which has good elasticity and low cost.

In order to ensure the reliable mounting of the fastener 42, as shown in FIG. 5, the noise reduction mounting member 4 further includes a nut 43, which is screwed on the fastener 42 and abuts against the fan body 3, so as to prevent the fastener 42 from falling off and ensure a more stable and reliable connection. It should be noted that the second mounting hole 31 is a threaded hole, so as to ensure the reliability of the fastener 42.

Preferably, in this embodiment, the preset distance between the fan body 3 and the fan guard 2 is greater than or equal to 10 mm, with this preset distance, the generation of high-order vortex noise of the fan body 3 can be avoided, which effectively reduces the aerodynamic noise of the fan body 3 and improves the sound quality.

The principle of obtaining the preset distance is described hereinafter. For the vortex formed by the air flowing through the fan guard 2, a sound pressure equation considering only the influence of a dipole source is as follows.

$$p(x, t) = \frac{1}{4\pi} \iiint\limits_{V} \frac{1}{r} \left[ -\frac{\partial F_i}{\partial y_i} \right] dV(y, \tau)$$

Where, p is a sound pressure, r is a distance from a coordinate origin to a point in the sound source field, Fi is a pulse force per unit volume, x is a position vector of a field point, y is a position vector of a source point, and τ is a delay time. In order to obtain the explicit relationship between the sound pressure p and aerodynamic force in sound source field, Hemholz equation is introduced:

$$\iiint_V \frac{\partial F_i}{\partial y_i} g(\boldsymbol{x}, \boldsymbol{y}, \omega) \mathrm{d}V = -\iiint_V F_i \frac{\partial g(\boldsymbol{x}, \boldsymbol{y}, \omega)}{\partial y_i} \mathrm{d}V$$

A far-field frequency-domain sound pressure formula of the fan body 3 under cylindrical coordinate system is derived from the above formulas:

$$p(\boldsymbol{x}, \omega) = \sum_{n=-\infty}^{+\infty} \frac{ik \cdot e^{ikor}}{4\pi r} \iint_s F(R, \theta_b, \omega) \cos\gamma \cos\beta Jn(k_0 R\varepsilon \cdot \beta) e^{in(\frac{\pi}{2} + \theta_b - \alpha)} \mathrm{d}S$$

Further, a sound pressure spectral density function can be obtained as follows:

$$\varphi = \frac{k_0{}^2 \cos\beta \cdot \cos\gamma}{16\pi^2 r^2} \Phi$$

Where, Φ is an autopower spectral density function of the whole sound source, k0 = ω/a₀ (a₀ is the sound velocity, ω is the circular frequency), β is the angle of the field point in cylindrical coordinates, and γ is an average mounting angle of blades. It can be seen from the sound pressure spectral density function that the sound pressure spectral density is inversely proportional to the square of the distance between the vortex generated by the fan guard 2 and the blades on the fan body 3. The smaller the distance is, the greater the sound pressure spectral density is (that is, the greater the noise is). The greater the distance is, the smaller the sound pressure spectral density is. When the distance reaches a certain value, the sound pressure spectral density tends to become a stable value. Therefore, in this embodiment, based on this principle and combined with the experiments, it is established that the preset distance between the fan body 3 and the fan guard 2 is greater than or equal to 10 mm.

In order to ensure that the preset distance between the fan body 3 and the fan guard 2 is greater than or equal to 10 mm, a height of the vibration damper 41 is greater than or equal to 10 mm. It should be noted in this embodiment that, since a thickness of the gasket 413 is negligible, it is only necessary to ensure that a height of the bushing 412 is greater than or equal to 10 mm.

Since a size of the fan assembly 100 is directly related to a weight of the fan assembly 100, and a natural frequency of the fan assembly 100 is negatively correlated with the weight of the fan assembly 100, that is, the larger the size of the fan assembly 100 is, the greater the weight is, the lower the natural frequency of the fan assembly 100 is, and the easier it is to excite the lower-order natural frequency of the fan assembly 100. In addition, in a case that the specification of the fan assembly 100 is different, the wind speed at the air inlet 11 is different, and the flow field characteristics at the air inlet 11 are also different. If the distance between the fan body 3 and the fan guard 2 at the air inlet 11 is kept unchanged, the greater the wind speed at the air inlet 11 is, the greater the vortex noise is. Therefore, the height of the vibration damper 41 according to this embodiment can be adjusted according to the size and specification of the fan body 3 on the fan assembly 100, so as to ensure that the vibration damper 41 can avoid the generation of high-order vortex noise and reduce the aerodynamic noise for the fan assembly 100 of different sizes or specifications.

**Second embodiment**

The structure of the fan assembly 100 in this embodiment is substantially the same with that in the first embodiment. The difference between the fan assembly 100 in this embodiment and the fan assembly in the first embodiment is that the fan body 3 is integrally formed with the noise reduction mounting member 4.

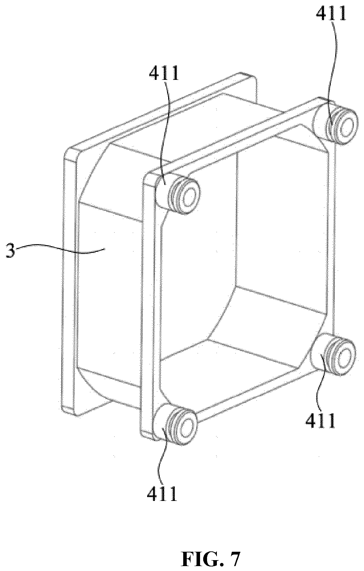

Specifically, as shown in Fig. 7, the fan body 3 and the vibration damping pad 411 are integrally formed, which improves the connection stability between the fan body 3 and the vibration damping pad 411, and facilitates the mounting of the fan body 3 on the fan bracket 1, which only requires to clamp the clamping groove 4112 of the vibration damping pad 411 into the third mounting hole 12.

Obviously, the above embodiments of the present application are merely examples for clear illustration of the present application, which are not intended to limit the implementation of the present application. For those skilled in the art, other changes or modifications in different forms may be made on the basis of the above illustration.

Any modification, equivalent substitution, or improvement made which falls within the scope of the invention as defined in the following claims are considered as a part of the present invention.

**Claims**

1.  A fan assembly (100), comprising:

    a fan body (3) and a noise reduction mounting member (4); wherein
    the fan body (3) is arranged to directly face an air inlet (11), and the air inlet is covered by a fan guard (2); and
    the noise reduction mounting member (4) is arranged at the fan body (3), to provide a preset distance between the fan body (3) and the fan guard (2), and the noise reduction mounting member (4) is configured to mount the fan body (3) and the fan guard (2) at a fan bracket (1) in a buffered manner,
    wherein the air inlet (11) is provided on the fan bracket (1),
    wherein the noise reduction mounting member (4) comprises:

    a vibration damper (41) arranged between the fan guard (2) and the fan body (3), and the vibration damper (41) is fixed on the fan bracket (1); and
    a fastener (42) configured to connect the fan guard (2), the vibration damper (41) and the fan body (3) with each other, **characterised in that** the vibration damper (41) comprises:
    a vibration damping pad (411) fixed on the fan bracket (1), wherein a through hole (4111) is provided in the vibration damping pad (411);
    a bushing (412) arranged in the through hole (4111) of the vibration damping pad (411); and
    a gasket (413) arranged on the bushing (412), wherein the fastener (42) passes through the fan guard (2), the gasket (413), the bushing (412) and the fan body (3) successively to connect the fan guard (2), the gasket (413), the bushing (412) and the fan body (3) with each other,

    wherein a clamping groove (4112) is circumferentially provided on an outer periphery of the vibration damping pad (411), and the fan bracket (1) is clamped and fixed in the clamping groove (4112).

2.  The fan assembly (100) according to claim 1, wherein the vibration damping pad (411) is a rubber pad or a spring.

3.  The fan assembly (100) according to claim 1, wherein a height of the vibration damper (41) is greater than or equal to 10 mm.

4.  The fan assembly (100) according to claim 1, wherein the noise reduction mounting member (4) further comprises:
    a nut (43) screwed on the fastener (42) and abutting against the fan body (3).

5.  The fan assembly (100) according to claim 1, wherein the fan body (3) is integrally formed with a part of the the noise reduction mounting member (4).

6.  The fan assembly (100) according to any one of claims 1 to 5, wherein a plurality of noise reduction mounting members (4) are provided, and the plurality of noise reduction mounting members (4) are arranged spaced apart along a circumferential direction of the fan body (3).

7.  The fan assembly (100) according to claim 1, wherein a plurality of fan bodies (3) are provided, and the plurality of fan bodies (3) are arranged spaced apart on the fan bracket (1).

8.  An inverter, comprising the fan assembly (100) according to any one of claims 1 to 7.

9.  The inverter according to claim 8, further comprising:

    a box (200); and
    heat dissipation fins (300) arranged on the box (200), wherein the fan assembly (100) is arranged to directly face the heat dissipation fins (300), and the fan assembly (100) is configured to dissipate heat for the heat dissipation fins (300).

**Patentansprüche**

1. Lüfteranordnung (100), umfassend:

   einen Lüfterkörper (3) und ein Geräuschreduzierungsmontageelement (4); wobei
   der Lüfterkörper (3) so angeordnet ist, dass er einem Lufteinlass (11) direkt zugewandt ist, und der Lufteinlass durch ein Lüftergitter (2) abgedeckt ist; und
   das Geräuschreduzierungsmontageelement (4) an dem Lüfterkörper (3) so angeordnet ist, dass es einen zuvor festgelegten Abstand zwischen dem Lüfterkörper (3) und dem Lüftergitter (2) bereitstellt, und das Geräuschreduzierungsmontageelement (4) dazu konfiguriert ist,
   den Lüfterkörper (3) und das Lüftergitter (2) in einer gepufferten Weise an einer Lüfterhalterung (1) zu montieren, wobei der Lufteinlass (11) auf der Lüfterhalterung (1) bereitgestellt ist,
   wobei das Geräuschreduzierungsmontageelement (4) Folgendes umfasst:

   einen Vibrationsdämpfer (41), der zwischen dem Lüftergitter (2) und dem Lüfterkörper (3) angeordnet ist, und wobei der Vibrationsdämpfer (41) auf der Lüfterhalterung (1) fixiert ist; und
   ein Befestigungselement (42), das dazu konfiguriert ist, das Lüftergitter (2), den Vibrationsdämpfer (41) und den Lüfterkörper (3) miteinander zu verbinden,
   **dadurch gekennzeichnet, dass** der Vibrationsdämpfer (41) Folgendes umfasst:

   ein Vibrationsdämpfungskissen (411), das auf der Lüfterhalterung (1) fixiert ist, wobei ein Durchgangsloch (4111) in dem Vibrationsdämpfungskissen (411) bereitgestellt ist;
   eine Muffe (412), die in dem Durchgangsloch (4111) des Vibrationsdämpfungskissens (411) angeordnet ist; und
   eine Dichtung (413), die auf der Muffe (412) angeordnet ist, wobei das Befestigungselement (42) nacheinander durch das Lüftergitter (2), die Dichtung (413), die Muffe (412) und den Lüfterkörper (3) verläuft, um das Lüftergitter (2), die Dichtung (413), die Muffe (412) und den Lüfterkörper (3) miteinander zu verbinden;
   wobei eine Klemmnut (4112) in Umfangsrichtung auf einem Außenumfang des Vibrationsdämpfungskissens (411) bereitgestellt ist und die Lüfterhalterung (1) in der Klemmnut (4112) verklemmt und fixiert ist.

2. Lüfteranordnung (100) nach Anspruch 1, wobei das Vibrationsdämpfungskissen (411) ein Gummikissen oder eine Feder ist.

3. Lüfteranordnung (100) nach Anspruch 1, wobei eine Höhe des Vibrationsdämpfers (41) größer als oder gleich 10 mm ist.

4. Lüfteranordnung (100) nach Anspruch 1, wobei das Geräuschreduzierungsmontageelement (4) ferner Folgendes umfasst:
   eine Mutter (43), die auf das Befestigungselement (42) aufgeschraubt ist und an dem Lüfterkörper (3) anliegt.

5. Lüfteranordnung (100) nach Anspruch 1, wobei der Lüfterkörper (3) einstückig mit einem Teil des Geräuschreduzierungsmontageelements (4) ausgebildet ist.

6. Lüfteranordnung (100) nach einem der Ansprüche 1 bis 5, wobei eine Vielzahl von Geräuschreduzierungsmontageelementen (4) bereitgestellt ist und die Vielzahl von Geräuschreduzierungsmontageelementen (4) im Abstand voneinander entlang einer Umfangsrichtung des Lüfterkörpers (3) angeordnet ist.

7. Lüfteranordnung (100) nach Anspruch 1, wobei eine Vielzahl von Lüfterkörpern (3) bereitgestellt ist und die Vielzahl von Lüfterkörpern (3) im Abstand voneinander an der Lüfterhalterung (1) angeordnet ist.

8. Wechselrichter, umfassend die Lüfteranordnung (100) nach einem der Ansprüche 1 bis 7.

9. Wechselrichter nach Anspruch 8, ferner umfassend:

   einen Kasten (200); und
   Wärmeableitungsrippen (300), die auf dem Kasten (200) angeordnet sind, wobei die Lüfteranordnung (100) so angeordnet ist, dass sie den Wärmeableitungsrippen (300) direkt zugewandt ist, und die Lüfteranordnung (100) dazu konfiguriert ist, Wärme für die Wärmeableitungsrippen (300) abzuleiten.

**Revendications**

1. Ensemble ventilateur (100), comprenant :

   un corps de ventilateur (3) et un élément de montage de réduction de bruit (4) ; dans lequel
   le corps de ventilateur (3) est disposé de manière à faire directement face à une entrée d'air (11), et l'entrée d'air est recouverte par une protection de ventilateur (2) ; et
   l'élément de montage de réduction de bruit (4) est disposé au niveau du corps de ventilateur (3), pour fournir une distance prédéfinie entre le corps de ventilateur (3) et la protection de ventilateur (2), et l'élément de montage de réduction de bruit (4) est configuré pour monter le corps de ventilateur (3) et la protection de ventilateur (2) au niveau d'un support de ventilateur (1) de manière tamponnée,
   dans lequel l'entrée d'air (11) est prévue sur le support de ventilateur (1),
   dans lequel l'élément de montage de réduction de bruit (4) comprend :

   un amortisseur de vibrations (41) disposé entre la protection de ventilateur (2) et le corps de ventilateur (3), et l'amortisseur de vibrations (41) est fixé sur le support de ventilateur (1) ; et
   un élément de fixation (42) configuré pour relier la protection de ventilateur (2), l'amortisseur de vibrations (41) et le corps de ventilateur (3) les uns aux autres,
   **caractérisé en ce que** l'amortisseur de vibrations (41) comprend :

   un tampon amortisseur de vibrations (411) fixé sur le support de ventilateur (1), dans lequel un trou traversant (4111) est prévu dans le tampon amortisseur de vibrations (411) ;
   une douille (412) disposée dans le trou traversant (4111) du tampon amortisseur de vibrations (411) ; et
   un joint (413) disposé sur la douille (412), dans lequel l'élément de fixation (42) traverse successivement la protection de ventilateur (2), le joint (413), la douille (412) et le corps de ventilateur (3) pour relier entre eux la protection de ventilateur (2), le joint (413), la douille (412) et le corps de ventilateur (3),
   dans lequel une rainure de serrage (4112) est prévue de manière circonférentielle sur une périphérie extérieure du tampon amortisseur de vibrations (411), et le support de ventilateur (1) est serré et fixé dans la rainure de serrage (4112).

2. Ensemble ventilateur (100) selon la revendication 1, dans lequel le tampon amortisseur de vibrations (411) est un tampon en caoutchouc ou un ressort.

3. Ensemble ventilateur (100) selon la revendication 1, dans lequel une hauteur de l'amortisseur de vibrations (41) est supérieure ou égale à 10 mm.

4. Ensemble ventilateur (100) selon la revendication 1, dans lequel l'élément de montage de réduction de bruit (4) comprend en outre :
   un écrou (43) vissé sur l'élément de fixation (42) et venant en butée contre le corps de ventilateur (3).

5. Ensemble ventilateur (100) selon la revendication 1, dans lequel le corps de ventilateur (3) est formé d'un seul tenant avec une partie de l'élément de montage de réduction de bruit (4).

6. Ensemble ventilateur (100) selon l'une quelconque des revendications 1 à 5, dans lequel une pluralité d'éléments de montage de réduction de bruit (4) sont prévus, et la pluralité d'éléments de montage de réduction de bruit (4) sont disposés de manière espacée le long d'une direction circonférentielle du corps de ventilateur (3).

7. Ensemble ventilateur (100) selon la revendication 1, dans lequel une pluralité de corps de ventilateur (3) sont prévus, et la pluralité de corps de ventilateur (3) sont disposés de manière espacée sur le support de ventilateur (1).

8. Onduleur, comprenant l'ensemble ventilateur (100) selon l'une quelconque des revendications 1 à 7.

9. Onduleur selon la revendication 8, comprenant en outre :

une boîte (200) ; et

des ailettes de dissipation de chaleur (300) disposées sur la boîte (200), l'ensemble ventilateur (100) étant disposé pour faire face directement aux ailettes de dissipation de chaleur (300), et l'ensemble ventilateur (100) étant configuré pour dissiper la chaleur pour les ailettes de dissipation de chaleur (300) .

FIG. 1

FIG. 2

**FIG. 3**

**FIG. 4**

**FIG. 5**

**FIG. 6**

411

411

3

411

411

**FIG. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6692226 B1